# EUROPEAN PATENT SPECIFICATION

(11) **EP 1 384 397 B1**
(45) Date of publication and mention of the grant of the patent: **05.05.2010**
(21) Application number: 02732646.1
(22) Date of filing: 19.04.2002
(51) Int. Cl.: H05K 7/14

(54) **PRINTED CIRCUIT BOARD ASSEMBLY DEVICE**
MONTAGEVORRICHTUNG FÜR LEITERPLATTE
DISPOSITIF D'ASSEMBLAGE DE CARTES DE CIRCUITS IMPRIMES

(30) Priority: 24.04.2001 IT MI20010868
(43) Date of publication of application: 28.01.2004
(73) Proprietor: ABB S.p.A., 20124 Milano (IT)
(72) Inventor: MORLACCHI, Carlo, I-20010 Arluno (IT); CARETTONI, Aldo, I-20020 Arese (IT)
(74) Representative: Zanoli, Enrico
(86) International application number: PCT/EP2002/004389
(87) International publication number: WO 2002/087300

(56) References cited:
- DE-A- 19 529 671
- DE-U- 8 328 337
- DE-U- 29 823 669
- JP-A- 61 107 199
- PATENT ABSTRACTS OF JAPAN vol. 016, no. 048 (E-1163), 6 February 1992 (1992-02-06) -& JP 03 252198 A (YOKOGAWA HEWLETT PACKARD LTD), 11 November 1991 (1991-11-11)

## Description

The present invention relates to a printed circuit board assembly device having improved functions and characteristics.

It is known that some modular electronic apparatuses, such as for example timers, use appropriate boards on which electronic circuits are printed and on which various components required for the use of said apparatuses are mounted.

In particular, currently commercially available modular apparatuses generally use two boards which are assembled together, according to various constructive solutions, so as to provide a sort of framework in which the boards are mutually spaced so as to leave room for the various components mounted thereon; the resulting assembly is then inserted in the housing of the apparatus.

In the background art, the methods with which the boards are mutually assembled and used inside the apparatuses have drawbacks and disadvantages.

In particular, a first constructive solution uses two supporting elements, which are arranged along two sides of the boards and are shaped so as to have means for fixing to said boards, so as to interconnect them structurally while keeping them mutually spaced; once the supporting elements have been fixed to the boards, one obtains a sort of frame, which is inserted monolithically within the housing of the apparatus. Although this solution allows adequate assembly of the boards and their correct use in the enclosure, it has the severe disadvantage that the two supporting elements that are used are structurally different from each other and that the resulting assembly of boards and supporting elements, indeed because of the constructive embodiment of the two supporting elements, is highly dependent on the type of apparatus and in particular on the type of housing in which it will be used. This entails an increase in the number of molds required and a consequent increase in production costs and in inventory codes to be managed, since it is necessary to adopt ad-hoc solutions according to the various applications, also as regards the components to be used and in particular the terminals to be mounted on the boards; moreover, there is also an increase in difficulties during the design of the electronic circuits, since one does not have a universally valid solution to which reference can be made.

A different solution that is currently used in practice instead entails mutually interconnecting the two boards by fixing thereto spacer pins or portions of additional boards used specifically as spacers. In these cases, one of the main limitations is the great difficulty of controlling and ensuring with the highest precision the mutual distance of the boards. Furthermore, this solution, like the preceding one, does not allow to provide structures that are adequately strong and have a self-sufficient mechanical stability; accordingly, even taking into account the difficulty in providing a precise mutual positioning of the boards, it is not possible to perform the necessary tests directly on the frame, but it is necessary to insert beforehand the entire assembly in the housing, with a consequent increase in testing difficulty, times and costs.

Moreover, one should not disregard the fact that in known kinds of solution the coupling between the boards and the connecting elements, be they supports, pins or pieces of spacer boards, is generally of a fixed type, and this, besides hindering or even preventing the disassembly of the parts, makes it substantially impossible to recycle them at the end of the useful life of the apparatus.

Finally, solutions of the currently known type do not allow to use simultaneously more than two boards, substantially reducing the potential features of the apparatuses as a whole.

DE-U-8328337 shows a device for assembling two circuit boards in a stacked arrangement, wherein each of two that support elements comprise coupling means for coupling respectively to a circuit board.

The aim of the present invention is to provide a device for assembling printed circuit boards that allows to obviate the above cited drawbacks and in particular allows to obtain a constructive solution that is entirely independent of the housing of the apparatus in which it will be used.

Within the scope of this aim, an object of the present invention is to provide a device for assembling printed circuit boards that allows to reduce production costs and in particular the number of molds required.

Another object of the present invention is to provide a device for assembling printed circuit boards in which the coupling to the boards occurs in an improved and simplified manner with respect to known types of device, at the same time allowing to ensure precisely the relative arrangement of the boards.

Another object of the present invention is to provide a device for assembling printed circuit boards that allows to obtain a structure that has adequate mechanical stability and strength, so as to be able to perform testing before insertion in the housing of an apparatus.

Another object of the present invention is to provide a device for assembling printed circuit boards in which the coupling among the various components allows, where necessary, easy disassembly of the parts and facilitates recycling of the components at the end of their useful life.

Not the last object of the present invention is to provide a device for assembling printed circuit boards that is highly reliable and relatively easy to manufacture at competitive costs.

This aim, these objects and others that will become apparent hereinafter are achieved by a device for assembling printed circuit boards, comprising a first supporting element and a second supporting element that have a substantially flat body, from one face of which first and second coupling means protrude transversely for coupling, respectively, to at least one first board and one second board, said first and second supporting elements being suitable to be arranged along two corresponding edges of said first and second boards and to be coupled to them so as to support them and stack them in a mutually spaced arrangement, said first and second supporting elements being structurally substantially identical to each other.

Further characteristics and advantages of the invention will become apparent from the description of preferred but not exclusive embodiments of the device according to the invention, illustrated only by way of non-limitative example in the accompanying drawings, wherein:
Figures 1 and 2 are perspective views of a supporting element used in the device according to the invention;
Figures 3 and 4 are perspective views of the device according to the invention, coupled respectively to two and three printed circuit boards.

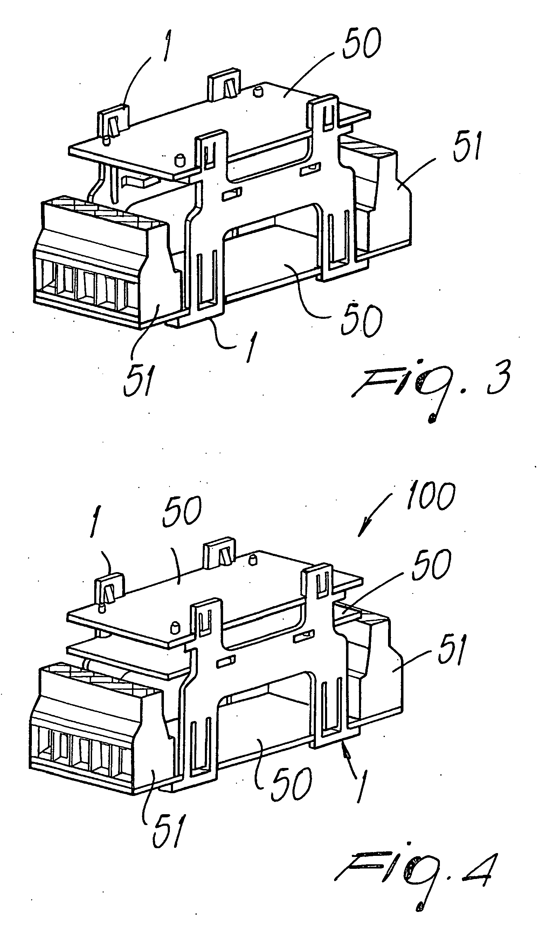

With reference to the above cited figures, the device for assembling printed circuit boards according to the invention, generally designated by the reference numeral 100 in Figures 3 and 4, comprises a first supporting element and a second supporting element, both designated by the reference numeral 1, which are suitable to be coupled to at least two boards 50 so as to support them and mutually connect them in manners explained in detail in the description that follows.

Advantageously, in the embodiment of the device according to the invention, the two supporting elements 1 are structurally substantially identical to each other, according to a constructive solution which, with respect to known types of solution, allows to reduce the number of molds required to produce the necessary constructive elements, with a consequent benefit from the point of view of cost and production.

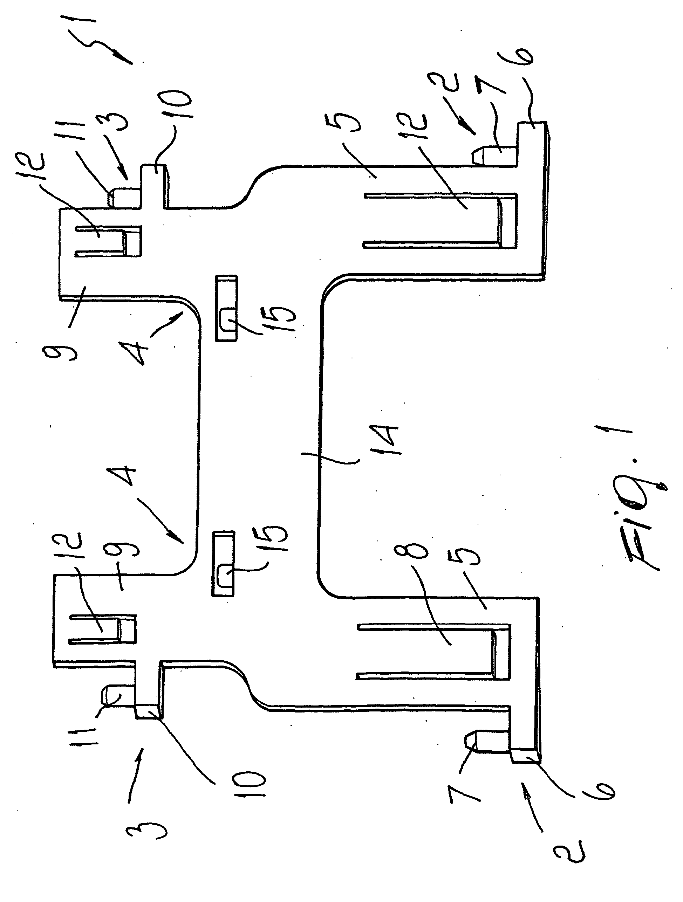

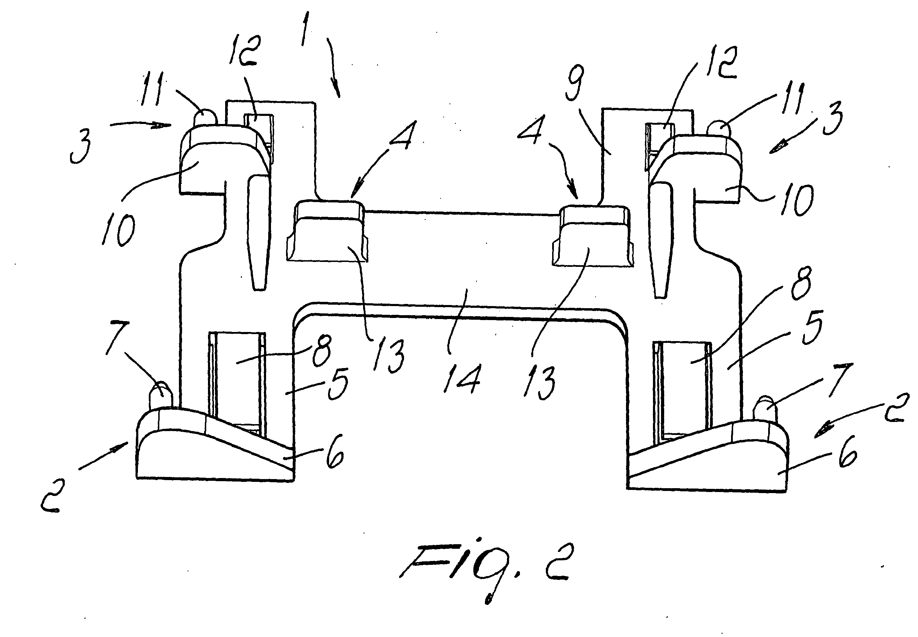

In particular, as shown in Figures 1 and 2, the supporting elements 1 have a flat body which is substantially H-shaped and is preferably made of plastics; first coupling means 2 and second coupling means 3 protrude transversely from one face of said body in the same direction and are meant to couple respectively to at least one first board and one second board 50. Furthermore, according to a preferred embodiment, the bodies of the supporting elements 1 have third coupling means 4, which also protrude transversely from the same face of the body in the same direction as the first and second coupling means 2 and 3 and are suitable to couple to a further third board 50.

As shown in Figures 1 and 2, the first coupling means 2 are arranged at the lower vertical sides 5 of the H-shaped profile, and comprise a flat element 6, which protrudes at right angles from the free end of the corresponding lower vertical side 5, so as to provide a supporting surface for a first board 50, and a flexible tab 8, which is cut out along the body of the same side 5 and protrudes transversely from it toward said flat element 6; a pin 7 is furthermore arranged on the flat element 6, protrudes at right angles from it and is suitable to enter a hole formed in the board 50.

In turn, the second coupling means 3 are arranged at the upper vertical sides 9 of the H-shaped profile and comprise a flat element 10, which protrudes at right angles from the corresponding upper vertical side 9, so as to form a supporting surface for a second board 50, and a flexible tab 12, which is cut out along the body of the same side 9 and protrudes transversely from it toward said flat element 10; on the flat element 10 there is also a pin 11, which protrudes at right angles from it and is suitable to enter a hole formed in the second board 50.

The third coupling means 4 comprise at least one flat element or protrusion 13, which is arranged along the horizontal side 14 of the H-shaped profile and is perpendicular thereto and is meant to support a third board 50; furthermore, on the flat element 13 there is a pin 15, which protrudes at right angles thereto and is suitable to enter a hole formed in the third board 50. In particular, in the embodiment shown in Figures 1 to 4, the third coupling means 4 comprise two flat elements 13 with corresponding pins 15, which are arranged at the ends of the horizontal side 14; as an alternative, the number and arrangement of said coupling means 4 can be changed appropriately according to the requirements of the application. For example, it is possible to provide a third planar element or protrusion 13 with a corresponding pin 15, arranged along the side 14 in an intermediate position between the other two elements 13, or to use a single flat element 13 arranged for example centrally along the side 14.

The practical use of the device 100 according to the invention is now described with particular reference to Figures 3 and 4.

During assembly, the two supporting elements 1 are arranged along two corresponding edges or sides of the boards to be assembled; then the boards are coupled to the elements 1. In particular, a first board 50 is arranged by resting it on the corresponding flat elements 6, so that the corresponding pins 7 enter holes formed in said board; during the insertion of the board, each flexible tab 8 flexes toward the body of the side 5, and after the passage of the edge protrudes again with a snap action, facilitating the resting of the first board 50 against the corresponding flat element 6 and keeping it in practice locked in said position.

Then a second board 50 is positioned and, in a manner similar to the one described above, is arranged by resting it on the corresponding flat elements 10, so that the corresponding pins 11 enter holes formed in said board; in this case also, during the insertion of the board each flexible tab 12 flexes toward the body of the side 9, and after the passage of the edge protrudes again with a snap action, facilitating the resting of the second board 50 against the corresponding flat element 10 and keeping it in practice locked in this position.

With this solution, the two supporting elements 1 are coupled detachably and substantially in a snap-together manner to the two boards 50, according to a solution that is advantageous both because assembly is easier and quicker and because the type of coupling provided allows the disassembly of the device, facilitating any replacement of parts or their recycling at the end of their useful life.

Another advantage is given by the fact that the device 100, by virtue of the presence of the third coupling means 4, furthermore allows to use an additional board 50, which also can be coupled detachably to the supporting elements 1; in this case, as shown in Figure 4, the third board 50 is coupled to each support 1, resting one edge thereof on the corresponding flat elements 13 so that the respective pins 15 enter corresponding holes formed in said board. This accordingly allows to increase the functional potential of the modular apparatus in which the device is used.

In this manner, both when using two boards and when using three boards, one obtains a frame-like structure in which the two supporting elements 1 are arranged along two parallel sides of the boards, supporting them structurally and stacking them so that they are mutually spaced, thus having the space required for components. The resulting assembly, by virtue of the particular shape and arrangement of the supporting elements 1, is entirely independent of the type of enclosure in which it will be used, allowing in particular to use standard components, such as for example the terminals 51 shown in Figures 3 and 4, which are mounted on the first board 50 and are unencumbered by the elements 1. In this manner, the device 100 ultimately constitutes a universally valid solution that can be used in various kinds of modular electronic protection and/or control apparatuses, such as for example timers, voltmeters, ammeters, electronic residual-current circuit breakers, twilight switches, et cetera. Accordingly, the present invention also relates to an electronic protection and/or control apparatus, **characterized in that** it comprises a device 100 according to what has been described above.

The described solution, in addition to the cited advantages, therefore allows to optimize the various construction types, to reduce production costs, to simplify the design of the printed circuits themselves, and to organize the management of inventory codes; furthermore, the presence of the various flat elements allows to assemble the boards by placing them at a precise and easily verifiable relative distance. Furthermore, the device 100 has a structure that is inherently adequately mechanically stable and strong, and this allows easier testing, since in this step the use of the housing is no longer necessary as instead occurs in the known art.

In practice it has been found that the assembly device according to the invention fully achieves the intended aim and objects, allowing to obtain a significant series of advantages with respect to known types of device. One should not dismiss the fact that all the innovative functions and inventive aspects of the device can be obtained by using commonly commercially available elements and materials with extremely low costs.

The device thus conceived is susceptible of numerous modifications and variations. In practice, the materials used, as well as the contingent shapes and dimensions, may be any according to the requirements and the state of the art.

## Claims

1. A device for assembling printed circuit boards, comprising a first supporting element and a second supporting element that have a substantially flat body, from one face of which first and second coupling means protrude transversely for coupling, respectively, to at least one first board and one second board, said first and second supporting elements being suitable to be arranged along two corresponding edges of said first and second boards and to be coupled to them so as to support them and stack them in a mutually spaced arrangement, said first and second supporting elements being structurally substantially identical to each other.

2. The device according to claim 1, **characterized in that** said first and second supporting elements are detachably coupled to said first and second boards.

3. The device according to claim 1 or 2, **characterized in that** said first and second supporting elements are connected in a substantially snap-together fashion to said first and second boards.

4. The device according to one or more of the preceding claims, **characterized in that** said first and second supporting elements comprise third coupling means, which protrude transversely from the respective body in the same direction as said first and second coupling means, said third coupling means being suitable to couple to a third board so that it is supported and stacked in a substantially spaced position with respect to said first and second boards.

5. The device according to one or more of the preceding claims, **characterized in that** the body of said first and second supporting elements has a substantially H-shaped configuration, in which the first and second coupling means are arranged respectively at the lower and upper vertical sides of said H-shape and the third coupling means are formed at the horizontal portion.

6. The device according to claim 5, **characterized in that** said first coupling means comprise a flat element, which protrudes at right angles from the free end of a corresponding lower vertical side and provides a supporting surface for said first board, a pin which protrudes at right angles from the flat element and is suitable to enter a hole formed in the first board, and a flexible tab, which is cut out along said lower vertical side and is suitable to facilitate the resting of the first board against the flat element and to keep it locked in this position.

7. The device according to claim 5, **characterized in that** said second coupling means comprise a flat element, which protrudes at right angles from a corresponding upper vertical side and provides a supporting surface for said second board, a pin which protrudes at right angles from the flat element and is suitable to enter a hole formed in the second board, and a flexible tab, which is cut out along said upper vertical side and is suitable to facilitate the resting of the second board against the flat element and to keep it locked in this position.

8. The device according to claim 5, **characterized in that** said third coupling means comprise at least one flat element, which is arranged along the horizontal side of the H-shaped profile and is perpendicular thereto and is meant to support said third board, and a pin, which protrudes at right angles from the flat element and is suitable to enter a hole formed in the third board.

9. The device according to one or more of the preceding claims, **characterized in that** said first and second supporting elements are made of plastics.

10. An electronic protection and/or control device, **characterized in that** it comprises a device according to one or more of the preceding claims.

## Patentansprüche

1. Vorrichtung zum Zusammensetzen von gedruckten Schaltungen, ein erstes Trägerelement und ein zweites Trägerelement mit einem im Wesentlichen ebenen Körper aufweisend, von dessen einer Fläche erste und zweite Koppelmittel zum Koppeln mit mindestens einer ersten Platine und einer zweiten Platine transversal vorstehen, wobei die ersten und zweiten Trägerelemente dafür ausgelegt sind, entlang zweier entsprechender Ränder der ersten und zweiten Platinen angeordnet und mit diesen gekoppelt zu werden, so dass sie diese tragen und in einer zueinander beabstandeten Anordnung stapeln, wobei die ersten und zweiten Trägerelemente im Wesentlichen gleich aufgebaut sind.

2. Vorrichtung nach Anspruch 1, **dadurch gekennzeichnet, dass** die ersten und zweiten Trägerelemente lösbar mit den ersten und zweiten Platinen gekoppelt sind.

3. Vorrichtung nach Anspruch 1 oder 2, **dadurch gekennzeichnet, dass** die ersten und zweiten Trägerelemente im Wesentlichen nach Art einer Schnappverbindung mit den ersten und zweiten Platinen verbunden sind.

4. Vorrichtung nach einem oder mehreren der vorangehenden Ansprüche, **dadurch gekennzeichnet, dass** die ersten und zweiten Trägerelemente dritte Koppelmittel aufweisen, die transversal von dem jeweiligen Körper in der gleichen Richtung wie die ersten und zweiten Koppelmittel vorstehen, wobei die dritten Koppelmittel dafür ausgelegt sind, mit einer dritten Platine derart gekoppelt zu werden, dass diese in einer in Bezug auf die ersten und zweiten Platinen im Wesentlichen beabstandeten Position getragen und gestapelt wird.

5. Vorrichtung nach einem oder mehreren der vorangehenden Ansprüche, **dadurch gekennzeichnet, dass** der Körper der ersten und zweiten Trägerelemente eine im Wesentlichen H-förmige Konfiguration aufweist, bei der die ersten und zweiten Koppelmittel an den unteren und oberen vertikalen Seiten der H-Form angeordnet sind und die dritten Koppelmittel am horizontalen Abschnitt ausgebildet sind.

6. Vorrichtung nach Anspruch 5, **dadurch gekennzeichnet, dass** das erste Koppelmittel aufweist: ein ebenes Element, das rechtwinklig vom freien Ende einer entsprechenden unteren vertikalen Seite vorsteht und eine Trägeroberfläche für die erste Platine bildet, einen Zapfen, der rechtwinklig von dem flachen Element vorsteht und der dafür ausgelegt ist, in ein Loch, das in der ersten Platine ausgebildet ist, einzudringen, und eine flexible Zunge, die entlang der unteren vertikalen Seite ausgeschnitten ist und die dafür ausgelegt ist, das Anliegen der ersten Platine an dem ebenen Element zu erleichtern und es in dieser Position festzulegen.

7. Vorrichtung nach Anspruch 5, **dadurch gekennzeichnet, dass** das zweite Koppelmittel aufweist: ein ebenes Element, das rechtwinklig von einer entsprechenden oberen vertikalen Seite vorsteht und eine Trägeroberfläche für die zweite Platine bildet, einen Zapfen, der rechtwinklig von dem ebenen Element vorsteht und der dafür ausgelegt ist, in ein Loch, das in der zweiten Platine ausgebildet ist, einzudringen, und eine flexible Zunge, die entlang der oberen vertikalen Seite ausgeschnitten ist und die dafür ausgelegt ist, das Anliegen der zweiten Platine an dem ebenen Element zu erleichtern und es in dieser Position festzulegen.

8. Vorrichtung nach Anspruch 5, **dadurch gekennzeichnet, dass** das dritte Koppelmittel aufweist: mindestens ein ebenes Element, das entlang der horizontalen Seite des H-förmigen Profils angeordnet ist und dazu senkrecht ist, und das dafür ausgelegt ist, die dritte Platine zu tragen, und einen Zapfen, der rechtwinklig von dem ebenen Element vorsteht und der dafür ausgelegt ist, in ein Loch, das in der dritten Platine ausgebildet ist, einzudringen.

9. Vorrichtung nach einem oder mehreren der vorangehenden Ansprüche, **dadurch gekennzeichnet, dass** die ersten und zweiten Trägerelemente aus Kunststoff gefertigt sind.

10. Elektronische Schutz- und/oder Steuervorrichtung, **dadurch gekennzeichnet, dass** sie eine Vorrichtung nach einem oder mehreren der vorangehenden Ansprüche aufweist.

## Revendications

1. Dispositif pour assembler des cartes de circuit imprimé, comprenant un premier élément de support et un second élément de support qui ont un corps sensiblement plat, à partir d'une face duquel des premier et second moyens de couplage font saillie de manière transversale pour se coupler, respectivement à au moins une première carte et une deuxième carte, lesdits premier et second éléments de support étant appropriés pour être agencés le long de deux bords correspondants desdites première et deuxième cartes et pour être couplés à ces dernières, afin de les supporter et de les empiler dans un agencement mutuellement espacé, lesdits premier et second éléments de support étant structurellement sensiblement identiques entre eux.

2. Dispositif selon la revendication 1, **caractérisé en ce que** lesdits premier et second éléments de support sont couplés de manière détachable auxdites première et deuxième cartes.

3. Dispositif selon la revendication 1 ou 2, **caractérisé en ce que** lesdits premier et second éléments de support sont raccordés d'une manière sensiblement encliquetable auxdites première et deuxième cartes.

4. Dispositif selon une ou plusieurs des revendications précédentes, **caractérisé en ce que** lesdits premier et second éléments de support comprennent des troisièmes moyens de couplage qui font saillie de manière transversale à partir du corps respectif dans la même direction que lesdits premier et deuxième moyens de couplage, lesdits troisièmes moyens de couplage étant appropriés pour se coupler à une troisième carte de sorte qu'elle est supportée et empilée dans une position sensiblement espacée par rapport auxdites première et deuxième cartes.

5. Dispositif selon une ou plusieurs des revendications précédentes, **caractérisé en ce que** le corps desdits premier et second éléments de support a une configuration sensiblement en forme de H, dans lequel les premier et deuxième moyens de couplage sont agencés respectivement au niveau des côtés verticaux inférieur et supérieur de ladite forme de H, et les troisièmes moyens de couplage sont formés au niveau de la partie horizontale.

6. Dispositif selon la revendication 5, **caractérisé en ce que** lesdits premiers moyens de couplage comprennent un élément plat, qui fait saillie en angle droit de l'extrémité libre d'un côté vertical inférieur correspondant et fournit une surface de support pour ladite première carte, une broche qui fait saillie en angle droit de l'élément plat et est appropriée pour entrer dans un trou formé dans la première carte, et une languette flexible, qui est découpée le long dudit côté vertical inférieur et est appropriée pour faciliter l'appuie de la première carte contre l'élément plat et la maintenir bloquée dans cette position.

7. Dispositif selon la revendication 5, **caractérisé en ce que** lesdits deuxièmes moyens de couplage comprennent un élément plat qui fait saillie en angle droit d'un côté vertical supérieur correspondant et fournit une surface de support pour ladite deuxième carte, une broche qui fait saillie en angle droit de l'élément plat et est appropriée pour entrer dans un trou formé dans la deuxième carte, et une languette flexible qui est découpée le long dudit côté vertical supérieur et est appropriée pour faciliter l'appuie de la deuxième carte contre l'élément plat et la maintenir bloquée dans cette position.

8. Dispositif selon la revendication 5, **caractérisé en ce que** lesdits troisièmes moyens de couplage comprennent au moins un élément plat qui est agencé le long du côté horizontal du profil en forme de H et est perpendiculaire à celui-ci et est censé supporter ladite troisième carte, et une broche qui fait saillie en angle droit de l'élément plat et est appropriée pour entrer dans un trou formé dans la troisième carte.

9. Dispositif selon une ou plusieurs des revendications précédentes, **caractérisé en ce que** lesdits premier et second éléments de support sont réalisés à partir d'une matière plastique.

10. Dispositif de protection et/ou de commande électronique, **caractérisé en ce qu'**il comprend un dispositif selon une ou plusieurs des revendications précédentes.
